# FASCICULE DE BREVET EUROPEEN

(11) **EP 2 234 468 B1**
(45) Date de publication et mention de la délivrance du brevet: **11.01.2012**
(21) Numéro de dépôt: 10305276.7
(22) Date de dépôt: 19.03.2010
(51) Int. Cl.: H05K 7/20

(54) **Module électrique**
Elektrisches Modul
Electric module

(30) Priorité: 23.03.2009 FR 0951822
(43) Date de publication de la demande: 29.09.2010
(73) Titulaire: Converteam Technology Ltd, Rugby Warwickshire CV21 1BU (GB)
(72) Inventeur: Godfroy, Guillaume, 78000, Versailles (FR); Lapassat, Nicolas, 91140, Villebon-sur-Yvette (FR)
(74) Mandataire: Blot, Philippe Robert Emile

(56) Documents cités:
- WO-A-01/13692
- GB-A- 2 342 713

## Description

La présente invention concerne un module électrique destiné à être immergé dans de l'eau, en particulier, un module électrique destiné à être immergé sous la mer.

Le document WO-A2-98/13838 décrit un module électrique destiné à être immergé dans de l'eau, du type comprenant :
- une enceinte étanche destinée à être immergée dans l'eau et renfermant une atmosphère comprenant un fluide caloporteur, dit fluide secondaire, par exemple de l'air ou de l'azote ;
- au moins un équipement électrique disposé dans l'enceinte étanche et qui, en fonctionnement, chauffe l'atmosphère,
- un premier circuit de refroidissement, dit circuit secondaire, du ou des équipements électriques, utilisant le fluide secondaire, le circuit secondaire comprenant :
   + un conduit de guidage muni de deux ouvertures, l'une, dite ouverture inférieure, étant disposée en dessous de l'autre, dite ouverte supérieure, en position d'utilisation du module électrique, le conduit de guidage étant disposé dans l'enceinte étanche de manière à guider l'atmosphère qui a été chauffée par le ou les équipements électriques vers son ouverture supérieure ;
   + un passage pour l'atmosphère, le passage reliant l'ouverture supérieure à l'ouverture inférieure par l'extérieur du conduit de guidage et étant délimité au moins en partie par l'enceinte étanche afin de permettre un refroidissement de l'atmosphère au contact de l'enceinte étanche ;

Dans ce document, le conduit de guidage est fixé à l'enceinte étanche par une multitude d'ailettes, thermiquement conductrices et, réparties le long de la circonférence de l'enceinte étanche.

Par ailleurs, pour des raisons évidentes de fonctionnement, il est souhaitable que l'environnement du ou des équipements électriques soit le plus sec possible.

A cet effet, il existe tout d'abord des systèmes actifs de déshumidification. Cependant, ces derniers ne sont pas suffisamment fiables pour une utilisation sous-marine, en particulière à des profondeurs supérieures à 500 mètres, dans laquelle toute intervention de réparation est très difficile.

Il existe également des systèmes passifs, tels que des billes de silicagel. Cependant, leur efficacité n'est pas satisfaisante.

Ainsi, un but de l'invention est de proposer un module électrique destiné à être immergé dans de l'eau, et permettant de garder, de manière fiable et efficace un environnement sec autour des équipements électriques.

Ainsi, un objet de l'invention est un module électrique destiné à être immergé dans de l'eau, du type précité, caractérisé en ce que le conduit de guidage est isolé thermiquement de l'enceinte étanche.

En effet, les inventeurs ont constaté qu'en isolant thermiquement le conduit de guidage de l'enceinte étanche, le conduit de guidage pouvait rester à une température élevée de sorte que le risque de condensation sur ce conduit est largement réduit. Ainsi, par rapport au document précédent, l'invention permet d'éviter que le conduit de guidage ne soit refroidi par l'enceinte étanche à cause des ailettes thermiquement conductrices, et que de la condensation se crée à l'intérieur du conduit de guidage et par conséquent à proximité des équipements électriques.

Suivant d'autres modes de réalisation, le module électrique comprend une ou plusieurs des caractéristiques suivantes, prises isolément ou suivant toutes les combinaisons techniquement possibles :
- le module électrique comprend des isolants thermiques de conduction, reliant le conduit de guidage à l'enceinte étanche, les isolants thermiques de conduction ayant une conductivité thermique inférieure ou égale à 1 W.m⁻¹.K⁻¹, les échanges thermiques par conduction entre le conduit de guidage et l'enceinte étanche se faisant uniquement au moyen des isolants thermiques de conduction ;
- le conduit de guidage est isolé thermiquement de l'enceinte étanche de telle sorte que, en condition d'utilisation du module électrique, le conduit de guidage soit à une température supérieure de 5°C à celle de l'enceinte étanche ;
- les isolants thermiques de conduction comprennent des moyens de fixation destinés à fixer le conduit de guidage à l'enceinte étanche ;
- les isolants thermiques de conduction sont constitués uniquement des moyens de fixation ;
- le ou les équipements électriques sont de puissance supérieure à 10 kVA, de préférence supérieure à 1 MVA ;
- au moins un équipement électrique de puissance est disposé dans le conduit de guidage, entre l'ouverture supérieure et l'ouverture inférieure ;
- tous les équipements électriques de puissance sont disposés dans le conduit de guidage, entre l'ouverture supérieure et l'ouverture inférieure ;
- le module électrique comprend un second circuit de refroidissement, dit circuit primaire, du ou des équipements électriques, utilisant un second fluide, dit fluide primaire, par exemple de l'eau ;
- l'enceinte étanche possède un fond destiné à recueillir du fluide primaire sous forme liquide, qui se serait échappé du circuit primaire et condensé sur l'enceinte, et le module électrique comprend une pompe destinée à récupérer le fluide primaire accumulé au fond de l'enceinte étanche et à réinjecter ce fluide primaire dans le circuit primaire ;
- le module électrique comprend un toit inférieur recouvrant le fond de l'enceinte étanche, et ce toit inférieur est relié thermiquement à l'enceinte étanche ;
- le fluide primaire est conducteur lorsque échappé dans l'atmosphère ;
- le fluide primaire a une résistivité inférieure à 1 MΩ.cm lorsque échappé dans l'atmosphère ;
- le module électrique comprend un système anti-retour, par exemple un clapet et/ou une électrovanne, disposé entre la pompe et le circuit primaire et destiné à empêcher une circulation du fluide primaire depuis le circuit primaire vers la pompe ;
- le module électrique comprend un système de chauffage, par exemple à base de résistance électrique, destiné à chauffer l'atmosphère dans le conduit de guidage, au moins de manière intermittente ;
- le module électrique comprend une sonde d'humidité destinée à fournir une mesure d'humidité dans le conduit de guidage, et le système de chauffage est

destiné à arrêter de chauffer lorsque la mesure passe sous un seuil prédéterminé, et à chauffer dans le cas contraire ;
- le système de chauffage est destiné à chauffer au démarrage ou redémarrage du ou des équipements électriques ;
- le système de chauffage est disposé dans la moitié inférieure du conduit de guidage, et, de préférence, dans l'ouverture inférieure du conduit de guidage ;
- l'enceinte étanche délimite un volume convexe ;
- le conduit de guidage est dépourvu d'ouverture autre que les ouvertures supérieure et inférieure ;
- le conduit de guidage est cylindrique ;
- le module électrique comprend des moyens de prévention de chute de condensation destinés à prévenir une chute de condensation depuis une partie de l'enceinte étanche située à la verticale du ou des équipements électriques en position d'utilisation du module électrique, sur le ou les équipements électriques ;
- les moyens de prévention de chute de condensation comprennent une couche d'isolation thermique s'étendant sur la partie située à la verticale du ou des équipements électriques, et destinée à empêcher la formation de condensation sur cette partie ;
- les moyens de prévention de chute de condensation comprennent un toit supérieur recouvrant l'ouverture supérieure ;
- le ou les équipements électriques comprennent un convertisseur de puissance.

Ces caractéristiques, ainsi que d'autres apparaîtront dans la description qui va suivre d'un mode de réalisation de l'invention, donné uniquement à titre d'exemple et faisant référence aux dessins annexés parmi lesquels :
- la figure 1 représente une vue en coupe de côté d'un module électrique suivant l'invention ;
- la figure 2 est une vue en coupe de côté d'une partie supérieure du module de la figure 1 suivant une variante de réalisation.

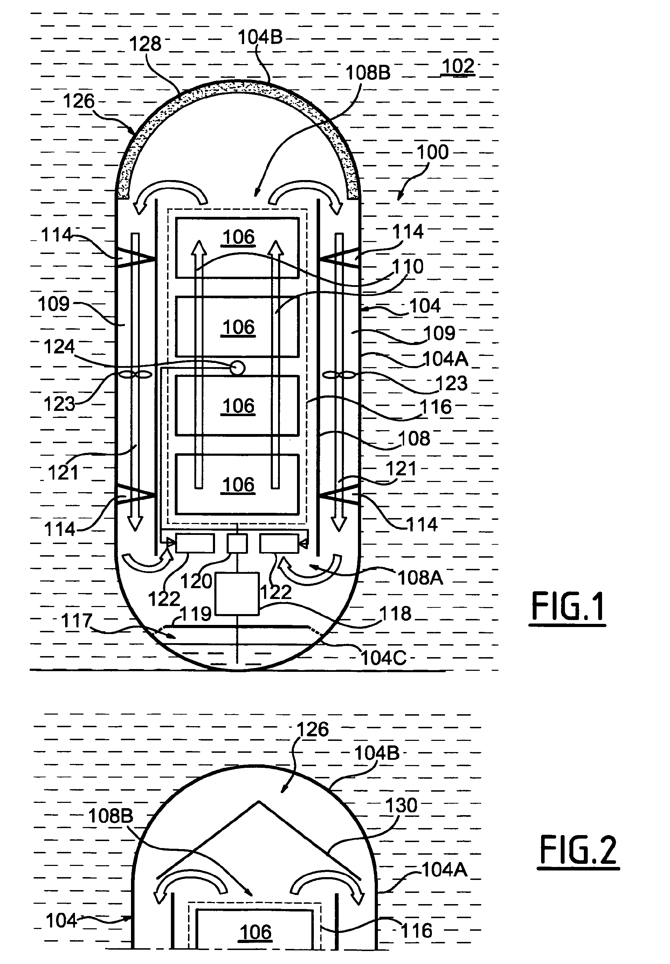

Un module électrique, désigné par la référence générale 100, représenté sur la figure 1 en position d'utilisation, est immergé dans de l'eau 102. Dans l'exemple décrit, le module électrique 100 est immergé sous l'eau de mer, à plus de 800 mètres de fond, de préférence à plus de 1000 mètres de fond. De préférence, le module électrique 100 repose sur le fond.

Le module électrique 100 comprend une enceinte étanche 104. L'enceinte étanche 104 est totalement immergée dans l'eau 102 et est au contact de l'eau 102. L'enceinte étanche 104 renferme une atmosphère comprenant un fluide caloporteur, appelé fluide secondaire pour le distinguer du fluide primaire qui sera décrit plus loin, par exemple de l'air ou de l'azote. De préférence, lors de la mise en fonctionnement du module électrique 100, l'atmosphère est constituée quasi exclusivement de fluide secondaire. L'atmosphère peut également contenir de l'eau, et de ce fait être humide.

L'enceinte étanche 104 comprend une partie centrale 104A cylindrique à section circulaire et des parties d'extrémité 104B, 104C en forme de coupelle fermant la partie centrale 104A cylindrique. En position d'utilisation du module électrique 100, l'enceinte étanche 104 est destinée à s'étendre avec la partie centrale 104A verticale avec l'une 104B des parties d'extrémité située en haut et l'autre 104C des parties d'extrémité située en bas. L'enceinte étanche 104 délimite un volume général convexe, ne comprenant en particulier aucun renfoncement délimitant une avancée de l'eau 102 vers l'intérieur du module électrique 100.

Le module électrique 100 comprend au moins un équipement électrique 106. Dans l'exemple décrit, le module électrique 100 comprend plusieurs dispositifs électriques (tous portant la même référence 106) disposés dans l'enceinte étanche 104. Le ou les équipements électriques 106 sont de préférence des équipements électriques de puissance, c'est-à-dire de puissance supérieure à 10 KVA. Il s'agit par exemple d'un convertisseur électrique de puissance. En fonctionnement, chaque équipement électrique 106 dégage de la chaleur et chauffe de ce fait l'atmosphère l'entourant.

Le module électrique 100 comprend en outre un conduit de guidage 108 de l'atmosphère chauffée. Dans l'exemple décrit, le conduit de guidage 108 a une forme cylindrique de section hexagonale, et s'étend verticalement. Le conduit de guidage 108 est muni de deux ouvertures 108A, 108B, l'une, dite ouverture inférieure 108A, est disposée en dessous de l'autre ouverture 108B, dite ouverture supérieure 108B. Dans l'exemple décrit, le conduit de guidage 108 est disposé dans l'enceinte étanche 104 de manière à entourer tous les équipements électriques de puissances 106. Ainsi, tous les équipements électriques 106 sont situés dans le conduit de guidage 108, entre son ouverture supérieure 108B et son ouverture inférieure 108A. La disposition du conduit de guidage 108 lui permet de guider l'atmosphère qui a été chauffée par le ou les équipements électriques 106 vers son ouverture supérieure 108B, par un phénomène de convection. Ce guidage est représenté par les flèches 110.

Le module électrique 100 comprend en outre des isolants thermiques de conduction 114, reliant le conduit de guidage 108 à l'enceinte étanche 104. Les isolants thermiques de conduction 114 ont une conductivité thermique inférieure ou égale à 1 W.m⁻¹.K⁻¹. En outre, les échanges thermiques par conduction entre le conduit de guidage 108 et l'enceinte étanche 104 se font uniquement au moyen des isolants thermiques de conduction 114. Dans l'exemple décrit, les isolants thermiques de conduction 114 sont constitués uniquement de moyens de fixation destinés à fixer le conduit de guidage 108 à l'enceinte étanche 104. Dans l'exemple décrit, les moyens de fixation 114 sont des bras de fixation sensiblement horizontaux en position d'utilisation du module électrique 100. Les isolants thermiques permettent de garder une différence de températures importante entre le conduit de guidage 108 et l'enceinte étanche 104, généralement une différence valant au moins 5 °C, et de préférence entre 15 °C et 30 °C. Dans l'exemple décrit, la température de l'enceinte étanche vaut entre 10 °C et 15 °C par exemple 13 °C, tandis que la température du conduit de guidage 108 et du fluide caloporteur circulant dans ce conduit de guidage 108 vaut entre 30 °C et 45 °C, par exemple entre 35 °C et 40 °C.

Le conduit de guidage 108 s'étend à distance de l'enceinte étanche 104 de sorte que l'espace les séparant forme un passage 109 pour l'atmosphère, le passage 109 reliant l'ouverture supérieure 108B à l'ouverture inférieure 108A par l'extérieur du conduit de guidage 108. Le passage 109 est délimité au moins en partie par l'enceinte étanche 104.

Ainsi, l'atmosphère chaude sortant de l'ouverture supérieur 108B rejoint l'ouverture inférieure 108A en circulant dans le passage 109. Lors de sa circulation dans le passage 109, l'atmosphère est refroidi au contact de l'enceinte étanche 104 et l'eau contenu dans l'atmosphère se condense sur l'enceinte étanche 104. La circulation dans le passage 109 est illustrée par les flèches 121.

De manière optionnelle, il est possible de favoriser la circulation de fluide caloporteur à l'aide de ventilateurs 123 disposés dans le passage 109 (comme cela est illustré) et/ou dans le conduit de guidage 108.

Ainsi, le conduit de guidage 108 et le passage 109 forment un circuit de refroidissement, appelé circuit secondaire pour le distinguer du circuit de refroidissement 116 qui sera décrit plus loin, des équipements électriques, utilisant le fluide secondaire.

En outre, l'humidité de l'atmosphère est maintenue hors du conduit de guidage 108 par sa condensation sur l'enceinte étanche 104, et, de ce fait, l'humidité est maintenue à distance du ou des équipements électriques 106.

Le conduit de guidage 108 isolé thermiquement de l'enceinte étanche 104, et le passage 109 forment ainsi un déshumidificateur de l'environnement du ou des équipements électriques 106. De préférence, ce dispositif permet d'avoir une humidité relative HR dans le conduit de guidage 108 comprise entre 5% et 85%, comme l'impose la norme IEC 60721-3-3, classe 3K3.

Le module électrique 100 comprend en outre un circuit de refroidissement 116 du ou des équipements électriques 106, ce circuit de refroidissement 116, dit circuit primaire, utilisant un fluide caloporteur, dit fluide primaire, par exemple de l'eau. Le circuit primaire 116 transporte le fluide primaire entre le ou les équipements électriques 106 (formant une source chaude) et une source froide, par exemple l'enceinte étanche 104 ou l'eau 102. Généralement, le circuit primaire permet de dissiper entre 80% et 95% de la chaleur générée par le ou les équipements électriques, les 20% à 5 % restant étant dissipé par le circuit secondaire.

Il arrive qu'une partie du fluide primaire s'échappe du circuit primaire 116, par exemple à cause de fuites. Ainsi, l'atmosphère comprend, en plus du fluide secondaire et de l'humidité d'origine, une fraction de fluide primaire.

La présence de fluide primaire dans l'atmosphère de l'enceinte étanche pose deux problèmes.

Tout d'abord, la quantité de fluide primaire présente dans le circuit primaire 116 diminue, ce qui risque de dégrader le fonctionnement du circuit primaire 116 et/ou de diminuer sa durée de vie. En outre, il arrive que le fluide primaire soit conducteur dans l'atmosphère, par exemple en ayant une résistivité inférieure à 1MΩ.cm.

Dans le cas de l'eau comme fluide primaire, il est possible de prévoir un système de désionisation dans le circuit primaire, rendant l'eau diélectrique dans le circuit primaire. Cependant, une fois dans l'atmosphère, l'eau a la possibilité de se re-ioniser pour avoir une résistivité inférieure à 1MΩ.cm. Dans d'autres modes de réalisation, un fluide primaire conducteur (résistivité inférieure à 1MΩ.cm). pourrait être directement utilisé dans le circuit primaire.

En tout état de cause, une fois dans l'atmosphère, ce fluide primaire risque de faire courir les mêmes risques aux équipements électriques 106 que l'humidité d'origine. La fonction de déshumidification du conduit de guidage 108 isolé thermiquement de l'enceinte étanche 104, et du passage 109, permet de maintenir le fluide primaire échappé du circuit primaire 116 hors du circuit de guidage 108, par sa condensation sur l'enceinte étanche 104 froide.

La partie basse 104C de l'enceinte forme un fond 117 destiné à recueillir la condensation, en particulier de fluide primaire, qui pourrait se former sur l'enceinte étanche 104 lors du passage de l'atmosphère dans, dans le passage 109.

Le fond 117 permet ainsi de récupérer du fluide primaire qui aurait fuit du circuit primaire 116, et qui se serait mélangé au fluide secondaire dans l'atmosphère de l'enceinte étanche 104.

Le module électrique 100 comprend en outre un toit inférieur 119 recouvrant le fond 117 de l'enceinte étanche 104. Le toit inférieur 119 est relié thermiquement à l'enceinte étanche 104. Les liaisons thermiques avec l'enceinte étanche 104 sont représentées en pointillés sur la figure 1. Le toit inférieur 119 est ainsi à une température proche de celle de l'enceinte étanche 104. Le toit inférieur 119 est destiné à empêcher que le fluide primaire accumulé dans le fond 117 de l'enceinte étanche 104 ne retourne dans l'atmosphère par évaporation. En effet, les vapeurs de fluide primaire se condensent au contact du toit inférieur 119 et retourne au fond 117.

Le module électrique 100 comprend en outre une pompe 118 destinée à récupérer du fluide primaire accumulé sous forme liquide au fond 117 de l'enceinte étanche 104, et à réinjecter ce fluide primaire dans le circuit de refroidissement 116. Il est ainsi possible d'augmenter la durée de vie du circuit de refroidissement 116.

Une pompe « simple », c'est-à-dire sans les moyens de filtrage décrit plus loin, est suffisante lorsque le fluide primaire est de l'eau (glycolée ou non), de sorte qu'il est tolérable que l'humidité d'origine soit récupérée en même temps que le fluide primaire condensé et injecté dans le circuit primaire de refroidissement, ou bien lorsque le fluide primaire n'est pas de l'eau, mais qu'il n'y a aucune humidité à l'origine dans l'enceinte. En revanche, lorsque le fluide primaire n'est pas de l'eau et que l'enceinte comprend à l'origine de l'humidité, la pompe comprend de préférence des moyens de filtrage destinés à empêcher l'humidité récupérée en même temps que le fluide primaire condensé, d'être injectée dans le circuit primaire de refroidissement.

Le module électrique 100 comprend en outre un système anti-retour 120, par exemple un clapet ou une électrovanne, disposé entre la pompe 118 et le circuit de refroidissement 116 et destiné à empêcher une circulation du fluide primaire depuis le circuit primaire 116 vers la pompe 118. Ainsi, en cas de panne de la pompe 118, le système anti-retour 120 empêche que le fluide primaire ne se déverse hors du circuit primaire 116 par la pompe 118 éteinte.

Le module électrique 100 comprend en outre un système de chauffage 122, par exemple à base de résistance électrique, destiné à chauffer le fluide caloporteur dans le conduit de guidage 108, lors d'un démarrage du ou des équipements électriques 106.

En effet, au démarrage ou au redémarrage du ou des équipements électriques 106, ces derniers ne dégagent généralement pas assez de chaleur pour permettre la mise en circulation du fluide caloporteur vers l'ouverture 108B. Le système de chauffage 122 permet cette mise en circulation.

De préférence, le système de chauffage 122 est disposé dans la moitié inférieure du conduit de guidage 108, et, de préférence encore, dans l'ouverture inférieure 108A du conduit de guidage.

Afin de n'utiliser le système de chauffage 122 que lorsque nécessaire, le module électrique 100 comprend une sonde d'humidité 124 destinée à fournir une mesure d'humidité dans le conduit de guidage 108. Le système de chauffage 122 est alors destiné à arrêter de chauffer lorsque la mesure produite par la sonde d'humidité 124 passe sous un seuil prédéterminé.

Le module électrique 100 comprend en outre des moyens 126 pour empêcher la chute de gouttes de condensation sur les équipements électriques 106. Dans l'exemple de la figure 1, ces moyens 126 comprennent une couche d'isolation thermique 128 s'étendant sur la partie supérieure 104B de l'enceinte étanche 104, au moins à la verticale au dessus de l'ouverture 108B, et sur laquelle la condensation ne se forme pas.

En variante représentée sur la figure 2, les moyens 126 comprennent un toit 130 recouvrant l'ouverture supérieure 108B et empêchant que la condensation formée sur la partie supérieure 104B de l'enceinte étanche 104, à la vertical au dessus de l'ouverture supérieure 108B, ne retombe dans le conduit du guidage 108, et donc sur les équipements électriques 106.

On remarquera que, dans les exemples précédents, le conduit de guidage 108 est dépourvu d'ouvertures autre que les ouvertures supérieure 108B et inférieure 108A, afin de bien canaliser le fluide caloporteur.

## Revendications

1. Module électrique destiné à être immergé dans de l'eau, du type comprenant :
- une enceinte étanche (104) destinée à être immergée dans l'eau et renfermant une atmosphère comprenant un fluide caloporteur, dit fluide secondaire, par exemple de l'air ou de l'azote ;
- au moins un équipement électrique (106) disposé dans l'enceinte étanche (104) et qui, en fonctionnement, chauffe l'atmosphère ;
- un premier circuit de refroidissement, dit circuit secondaire, du ou des équipements électriques (106), utilisant le fluide secondaire, le circuit secondaire comprenant :
+ un conduit de guidage (108) muni de deux ouvertures, l'une, dite ouverture inférieure (1 08A), étant disposée en dessous de l'autre, dite ouverte supérieure (108B), en position d'utilisation du module électrique, le conduit de guidage (108) étant disposé dans l'enceinte étanche (104) de manière à guider l'atmosphère qui a été chauffée par le ou les équipements électriques (106) vers son ouverture supérieure (108B) ;
+ un passage (109) pour l'atmosphère, le passage (109) reliant l'ouverture supérieure (108B) à l'ouverture inférieure (108A) par l'extérieur du conduit de guidage (108) et étant délimité au moins en partie par l'enceinte étanche (104) afin de permettre un refroidissement de l'atmosphère au contact de l'enceinte étanche (104) ;
**le module étant caractérisé en ce que** le conduit de guidage (108) est isolé thermiquement de l'enceinte étanche (104).

2. Module électrique selon la revendication 1, **caractérisé en outre en ce qu'**il comprend des éléments (114), reliant le conduit de guidage (108) à l'enceinte étanche (104), ces éléments (114) étant des isolants thermiques de conduction (114) ayant une conductivité thermique inférieure ou égale à 1 W.m⁻¹.K⁻¹, les échanges thermiques par conduction entre le conduit de guidage (108) et l'enceinte étanche (104) se faisant uniquement au travers de ces éléments (114).

3. Module électrique selon l'une la revendication 1 ou 2, **caractérisé en outre en ce que** le ou les équipement électrique (106) sont de puissance supérieure à 10 kVA, de préférence supérieure à 1 MVA.

4. Module électrique selon la revendication 3, **caractérisé en outre en ce que** tous les équipements électriques de puissance (106) sont disposés dans le conduit de guidage (108), entre l'ouverture supérieure (108B) et l'ouverture inférieure (108A).

5. Module électrique selon l'une quelconque des revendications 1 à 4, **caractérisé en outre en ce qu'**il comprend un second circuit de refroidissement, dit circuit primaire (116), du ou des équipements électriques (106), utilisant un second fluide, dit fluide primaire, par exemple de l'eau.

6. Module électrique selon la revendication 5, **caractérisé en outre en ce que** l'enceinte étanche (104) possède un fond (117) destiné à recueillir du fluide primaire sous forme liquide, qui se serait échappé du circuit primaire (116) et condensé sur l'enceinte (104), et **en ce qu'**il comprend une pompe (118) destinée à récupérer le fluide primaire accumulé au fond (117) de l'enceinte étanche (104) et à réinjecter ce fluide primaire dans le circuit primaire (116).

7. Module électrique selon la revendication 6, **caractérisé en outre en ce qu'**il comprend un toit inférieur (119) recouvrant le fond (117) de l'enceinte étanche (104), et **en ce que** ce toit inférieur (119) est relié thermiquement à l'enceinte étanche (104).

8. Module électrique selon l'une quelconque des revendications 5 à 7, **caractérisé en outre en ce qu'**il comprend un système anti-retour (120), par exemple un clapet et/ou une électrovanne, disposé entre la pompe (118) et le circuit primaire (116) et destiné à empêcher une circulation du fluide primaire depuis le circuit primaire (116) vers la pompe (118).

9. Module électrique selon l'une quelconque des revendications 1 à 8, **caractérisé en outre en ce qu'**il comprend un système de chauffage (122), par exemple à base de résistance électrique, destiné à chauffer l'atmosphère dans le conduit de guidage (108), au moins de manière intermittente.

10. Module électrique selon la revendication 9, **caractérisé en outre en ce qu'**il comprend une sonde d'humidité (124) destinée à fournir une mesure d'humidité dans le conduit de guidage (108), et **en ce que** le système de chauffage (122) est destiné à arrêter de chauffer lorsque la mesure passe sous un seuil prédéterminé, et à chauffer dans le cas contraire.

11. Module électrique selon la revendication 9 ou 10, **caractérisée** outre en ce que le système de chauffage (122) est disposé dans la moitié inférieure du conduit de guidage (108), et, de préférence, dans l'ouverture inférieure (108A) du conduit de guidage (108).

12. Module électrique selon l'une quelconque des revendications 1 à 11, **caractérisé en outre en ce que** le conduit de guidage (108) est dépourvu d'ouverture autre que les ouvertures supérieure (108B) et inférieure (1 08A).

13. Module électrique selon l'une quelconque des revendications 1 à 12, **caractérisé en outre en ce que** le conduit de guidage (108) est cylindrique.

14. Module électrique selon l'une quelconque des revendications 1 à 13, **caractérisé en outre en ce qu'**il comprend des moyens de prévention de chute de condensation (126) destinés à prévenir une chute de condensation depuis une partie de l'enceinte étanche (104) située à la verticale du ou des équipements électriques (106) en position d'utilisation du module électrique, sur le ou les équipements électriques (106).

15. Module électrique selon l'une quelconque des revendications 1 à 14, **caractérisé en outre en ce que** le ou les équipements électriques (106) comprennent un convertisseur électrique de puissance.

## Claims

1. An electric module intended to be submerged in water, of the type comprising:
- a sealed enclosure (104) intended to be submerged in water and containing an atmosphere comprising a coolant, called secondary fluid, for example air or nitrogen;
- at least one piece of electric equipment (106) arranged in the sealed enclosure (104) and which, during operation, heats the atmosphere;
- a first cooling circuit, called secondary circuit, of the piece(s) of electrical equipment (106), using the secondary fluid, the secondary fluid comprising:
+ a guide pipe (108) provided with two openings, one, called lower opening (108A), being arranged below the other, called upper opening (108B), in the usage position of the electric module, the guide pipe (108) being arranged in the sealed enclosure (104) so as to guide the atmosphere that has been heated by the piece(s) of electrical equipment (106) toward its upper opening (108B);
+ a passage (109) for the atmosphere, the passage (109) connecting the upper opening (108B) to the lower opening (108A) through the outside of the guide pipe (108) and being delimited at least partially by the sealed enclosure (104) in order to allow cooling of the atmosphere in contact with the sealed enclosure (104);
the module being **characterized in that** the guide pipe (108) is thermally insulated from the sealed enclosure (104).

2. The electric module according to claim 1, also **characterized in that** it comprises elements (114), connecting the guide pipe (108) to the sealed enclosure (104), said elements (114) being thermal conduction insulators (114) having a thermal conductivity lower than or equal to 1 W.m⁻¹.K⁻¹, the conduction heat exchanges between the guide pipe (108) and the sealed enclosure (104) being done only through those elements (114).

3. The electric module according to one of claims 1 or 2, also **characterized in that** the piece(s) of electric equipment (106) have a power greater than 10 kVA, preferably greater than 1 MVA.

4. The electric module according to claim 3, also **characterized in that** all of the pieces of electrical power equipment (106) are arranged in the guide pipe (108), between the upper opening (108B) and the lower opening (108A).

5. The electric module according to any one of claims 1 to 4, also **characterized in that** it comprises a second cooling circuit, called primary circuit (116), for the piece(s) of electric equipment (106), using a second fluid, called primary fluid, for example water.

6. The electric module according to claim 5, also **characterized in that** the sealed enclosure (104) has a bottom (117) intended to collect the primary fluid in liquid form having escaped from the primary circuit (116) and condensed on the enclosure (104), and **in that** it comprises a pump (118) intended to recover the primary fluid accumulated in the bottom (117) of the sealed enclosure (104) and to reinject that primary fluid into the primary circuit (116).

7. The electric module according to claim 6, also **characterized in that** it comprises a lower roof (119) covering the bottom (117) of the sealed enclosure (104), and **in that** the lower roof (119) is thermally connected to the sealed enclosure (104).

8. The electric module according to any one of claims 5 to 7, also **characterized in that** it comprises a check system (120), for example a valve and/or a solenoid valve, arranged between the pump (118) and the primary circuit (116) and intended to prevent a circulation of the primary fluid from the primary circuit (116) toward the pump (118).

9. The electric module according to any one of claims 1 to 8, also **characterized in that** it comprises a heating system (122), for example resistance-based, intended to heat the atmosphere in the guiding pipe (108), at least intermittently.

10. The electric module according to claim 9, also **characterized in that** it comprises a humidity probe (124) intended to provide a humidity measurement in the guide pipe (108), and **in that** the heating system (122) is intended to stop heating when the measurement goes below a predetermined threshold, and to heat otherwise.

11. The electric module according to claim 9 or 10, also **characterized in that** the heating system (122) is arranged in the lower half of the guide pipe (108), and preferably in the lower opening (108A) of the guide pipe (108).

12. The electric module according to any one of claims 1 to 11, also **characterized in that** the guide pipe (108) is provided without any openings other than the upper (108B) and lower (108A) openings.

13. The electric module according to any one of claims 1 to 12, also **characterized in that** the guide pipe (108) is cylindrical.

14. The electric module according to any one of claims 1 to 13, also **characterized in that** it comprises means for preventing a condensation drop (126) intended to prevent a condensation drop from part of the sealed enclosure (104) situated at the vertical of the piece(s) of electrical equipment (106) in the usage position of the electric module, on the piece(s) of electric equipment (106).

15. The electric module according to any one of claims 1 to 14, also **characterized in that** the piece(s) of electric equipment (106) comprise an electric power converter.

## Patentansprüche

1. Elektrisches Modul, das dazu bestimmt ist, in Wasser eingetaucht zu sein, der Bauart, die umfasst:
- einen dichten Behälter (104), der dazu bestimmt ist, in Wasser eingetaucht zu sein und eine Atmosphäre einschließt, die ein sogenanntes sekundäres Wärmeträgerfluid, umfasst, zum Beispiel Luft oder Stickstoff,
- mindestens eine elektrische Ausrüstung (106), die in dem dichten Behälter (104) angeordnet ist und die eingeschaltet die Atmosphäre beheizt,
- einen sogenannten sekundären ersten Kühlkreis der elektrischen Ausrüstung(en) (106), der das sekundäre Fluid nutzt, wobei der sekundäre Kreis umfasst:
+ eine mit zwei Öffnungen ausgestattete Führungsleitung (108), wobei eine sogenannte untere Öffnung (108A) in Verwendungsstellung des elektrischen Moduls unter der anderen sogenannten oberen Öffnung (108B) angeordnet ist, wobei die Führungsleitung (108) in dem dichten Behälter (104) derart angeordnet ist, dass die Atmosphäre, die von der oder den elektrischen Ausrüstung(en) (106) beheizt wurde, zu ihrer oberen Öffnung (108B) geführt wird,
+ einen Durchgang (109) für die Atmosphäre, wobei der Durchgang (109) die obere Öffnung (108B) mit der unteren Öffnung (108A) außerhalb der Führungsleitung (108) verbindet und mindestens teilweise durch den dichten Behälter (104) begrenzt ist, um eine Kühlung der Atmosphäre im Kontakt mit dem dichten Behälter (104) zu ermöglichen,
wobei das Modul **dadurch gekennzeichnet ist, dass** die Führungsleitung (108) vom dichten Behälter (104) thermisch isoliert ist.

2. Elektrisches Modul nach Anspruch 1, außerdem **dadurch gekennzeichnet, dass** es Elemente (114) umfasst, die die Führungsleitung (108) mit dem dichten Behälter (104) verbinden, wobei diese Elemente (114) thermisch leitende Dämmstoffe (114) mit einer thermische Leitfähigkeit von unter oder gleich 1 W.m⁻¹.K⁻¹ sind, wobei der thermische Austausch durch Leitung zwischen der Führungsleitung (108) und dem dichten Behälter (104) ausschließlich mit diesen Elementen (114) erfolgt.

3. Elektrisches Modul nach einem der Ansprüche 1 oder 2, außerdem **dadurch gekennzeichnet, dass** die elektrische(n) Ausrüstung(en) (106) eine Leistung von über 10 kVA, vorzugsweise von über 1 MVA, hat/haben.

4. Elektrisches Modul nach Anspruch 3, außerdem **dadurch gekennzeichnet, dass** alle elektrischen Leistungsausrüstungen (106) in der Führungsleitung (108) zwischen der oberen Öffnung (108B) und der unteren Öffnung (108A) angeordnet sind.

5. Elektrisches Modul nach einem der Ansprüche 1 bis 4, außerdem **dadurch gekennzeichnet, dass** es einen zweiten sogenannten primären Kühlkreis (116) der elektrischen Ausrüstung(en) (106) umfasst, der ein zweites sogenanntes primäres Fluid, zum Beispiel Wasser, verwendet.

6. Elektrisches Modul nach Anspruch 5, außerdem **dadurch gekennzeichnet, dass** der dichte Behälter (104) einen Boden (117) besitzt, der dazu bestimmt ist, Primärfluid in flüssiger Form zu sammeln, das aus dem Primärkreis (116) ausgetreten ist und am Behälter (104) kondensiert hat, und dass es eine Pumpe (118) umfasst, die dazu bestimmt ist, das Primärfluid, das sich am Boden (117) des dichten Behälter (104) angesammelt hat, aufzunehmen und dieses Primärfluid wieder in den Primärkreis (116) einzuspeisen.

7. Elektrisches Modul nach Anspruch 6, außerdem **dadurch gekennzeichnet, dass** es ein unteres Dach (119) umfasst, das den Boden (117) des dichten Behälters (104) abdeckt, und dass dieses untere Dach (119) mit dem dichten Behälter (104) thermisch verbunden ist.

8. Elektrisches Modul nach einem der Ansprüche 5 bis 7, außerdem **dadurch gekennzeichnet, dass** es ein Rücklaufsperrsystem (120), zum Beispiel eine Klappe und/oder ein Elektroventil, umfasst, das zwischen der Pumpe (118) und dem Primärkreis (116) angeordnet und dazu bestimmt ist, eine Zirkulation des Primärfluids vom Primärkreis (116) zur Pumpe (118) zu verhindern.

9. Elektrisches Modul nach einem der Ansprüche 1 bis 8, außerdem **dadurch gekennzeichnet, dass** es ein Heizsystem (122), zum Beispiel auf elektrischer Widerstandsbasis, umfasst, das dazu bestimmt ist, die Atmosphäre in der Führungsleitung (108) zumindest intermittierend zu beheizen.

10. Elektrisches Modul nach Anspruch 9, außerdem **dadurch gekennzeichnet, dass** es eine Feuchtigkeitssonde (124) umfasst, die dazu bestimmt ist, einen Feuchtigkeitsmesswert in die Führungsleitung (108) zu liefern, und dass das Heizsystem (122) dazu bestimmt ist, das Heizen einzustellen, wenn der Messwert unter eine vorbestimmte Schwelle fällt und im gegenteiligen Fall zu heizen.

11. Elektrisches Modul nach Anspruch 9 oder 10, außerdem **dadurch gekennzeichnet, dass** das Heizsystem (122) in der unteren Hälfte der Führungsleitung (108) angeordnet ist und vorzugsweise in der unteren Öffnung (108A) der Führungsleitung (108).

12. Elektrisches Modul nach einem der Ansprüche 1 bis 11, außerdem **dadurch gekennzeichnet, dass** die Führungsleitung (108) keine anderen Öffnungen als die obere (108B) und untere (108A) Öffnung hat.

13. Elektrisches Modul nach einem der Ansprüche 1 bis 12, außerdem **dadurch gekennzeichnet, dass** die Führungsleitung (108) zylindrisch ist.

14. Elektrisches Modul nach einem der Ansprüche 1 bis 13, außerdem **dadurch gekennzeichnet, dass** es Mittel umfasst, die einem Absinken der Kondensation (126) vorbeugen, die dazu bestimmt sind, einem Absinken der Kondensation von einem Abschnitt des dichten Behälters (104) vorzubeugen, der sich vertikal zu der oder den elektrischen Ausrüstung(en) (106) in Verwendungsstellung des elektrischen Moduls auf der oder den elektrischen Ausrüstung(en) (106) befindet.

15. Elektrisches Modul nach einem der Ansprüche 1 bis 14, außerdem **dadurch gekennzeichnet, dass** die elektrische(n) Ausrüstung(en) (106) einen elektrischen Leistungswandler umfasst/umfassen.
